# EUROPEAN PATENT APPLICATION

(11) **EP 3 382 828 A1**
(43) Date of publication of application: **03.10.2018**
(21) Application number: 17164121.0
(22) Date of filing: 31.03.2017
(51) Int. Cl.: H01S 5/42, H01S 5/026, H01S 5/183

(54) **INHERENTLY SAFE LASER ARRANGEMENT COMPRISING A VERTICAL CAVITY SURFACE EMITTING LASER**

(71) Applicant: Koninklijke Philips N.V., 5656 AE Eindhoven (NL)
(72) Inventor: GRONENBORN, Stephan, 5656 AE Eindhoven (NL); MOENCH, Holger, 5656 AE Eindhoven (NL)
(74) Representative: de Haan, Poul Erik

(57) **Abstract**

The invention describes a laser arrangement comprising at least one Vertical Cavity Surface Emitting Laser being arranged to emit laser light (150), the at least one Vertical Cavity Surface Emitting Laser comprises a first electrode (100), a semiconductor substrate (101), a first distributed Bragg reflector (110), an active layer (115), a second distributed Bragg reflector (120) and a second electrode (125), wherein the active layer (115) is sandwiched between the first distributed Bragg reflector (110) and the second distributed Bragg reflector (120), wherein the first electrode (100) and the second electrode (125) are arranged to provide an electrical current across the active layer (115) to generate laser light (150), and wherein the laser arrangement comprises an optical structure (140) arranged to increase a laser emission angle (156) of the laser light (150) for increasing eye safety of the laser arrangement, wherein the optical structure (140) is an integrated part of a semiconductor layer structure of the laser arrangement.

The invention further describes a lighting device comprising such a laser arrangement and a method of manufacturing such a laser arrangement.

## Description

### FIELD OF THE INVENTION:

The invention relates to an inherently safe laser arrangement comprising a Vertical Cavity Surface Emitting Laser (VCSEL), a lighting device comprising such a laser arrangement and a method of manufacturing the laser arrangement.

### BACKGROUND OF THE INVENTION:

Laser arrangements comprising a VCSEL or a VCSEL array can be used as infrared illumination device. Using short pulses VCSEL arrays are, for example, applied in time of flight applications. Such applications comprise e.g. short-range gesture recognition for portable devices and 3D space recognition. VCSEL arrays of about 1mm² area with output power in the 1-10W range are discussed for such applications. A specific field of illumination is defined by the application (e.g. a time of flight camera observing e.g. 70°x50°). The typical emission pattern of a VCSEL array is rotational symmetric with a cone of e.g. 20°.

Laser safety especially in case of a laser arrangement comprised in a consumer product is essential in order to increase customer acceptance and to fulfill safety regulations. It has especially to be avoided that laser safety measures can be bypassed in a simple way e.g. by manipulation of the laser arrangement.

US 2007/0103643 A1 discloses in this respect a laser light source unit in which, when a laser is taken out of the chassis or the like, a laser thereof is assuredly rendered incapable of emitting. The laser light source unit includes a laser light source portion having a light oscillation portion emitting light, a fixing member that fixes the laser light source portion, an interrupting means that, simultaneously with a movement of removing the laser light source portion off the fixing member, interrupts a current path for supplying a current to the light oscillation portion in the laser light source portion.

### SUMMARY OF THE INVENTION:

It is an object of the present invention to provide an improved inherently safe laser arrangement comprising a VCSEL.

The invention is described in the independent claims. Preferred embodiments are described in the dependent claims or are described in the subsequent portions of the description.

According to a first aspect a laser arrangement comprising at least one Vertical Cavity Surface Emitting Laser being arranged to emit laser light is provided. The at least one Vertical Cavity Surface Emitting Laser comprises a first electrode, a semiconductor substrate, a first distributed Bragg reflector, an active layer, a second distributed Bragg reflector and a second electrode. The active layer is sandwiched between the first distributed Bragg reflector and the second distributed Bragg reflector. The first electrode and the second electrode are arranged to provide an electrical current across the active layer. The laser arrangement comprises an optical structure arranged to increase a laser emission angle of the laser light for increasing eye safety of the laser arrangement. The optical structure is an integrated part of a semiconductor layer structure of the laser arrangement. The semiconductor layer structure of the laser arrangement may optionally comprise further semiconductor layers supporting the functions of the functional elements like electrodes, reflectors, active layer and the like described above.

The optical structure may be arranged to reduce brightness of the laser arrangement to make the laser arrangement no longer subject to laser safety regulations. Safety regulations for Light Emitting Diodes (LED) may be applicable which are less restricted and which are well accepted in consumer products in which it may not be possible to deal with laser safety. Integration of an optical structure arranged to increase the laser emission angle of the laser light in the semiconductor layer structure provides an inherently safe device because the optical structure cannot be removed without destruction of the laser arrangement. Furthermore, the high refractive index of the semiconductor layers and especially the gallium arsenide substrate (n ∼ 3.5) of the laser arrangement guarantees that the laser emission angle is sufficiently increased even in case of submersion with a liquid which is usually characterized by a refractive index of n<1.5. The laser emission angle is defined by the full angle enclosing an optical axis of the respective VCSEL or VCSEL array at which the intensity of the laser light in the far field is reduced to 50% in comparison to the maximum intensity of the laser light (Full Width at Half Maximum-FWHM) if the laser emission is characterized by a fundamental Gaussian beam. An optical structure may be arranged to increase the emission cone of around 20°. The laser emission angle may, for example, be increased to a cone of 40° around the optical axis of the laser arrangement.

The optical structure may comprise a refractive diffusor or a diffractive diffusor.

A refractive diffusor is arranged such that the laser light is refracted by means of geometric structures which are integrated in the semiconductor layer structure. The geometric structures may comprise microlens arrays, especially random microlens arrays with different diameters and/or focal length and/or decenter and/or apertures, micro-prisms, micro-pyramids, micro-axicons, wavy Freeform Surface to randomly increase the emission angle, cylinder lenses and the like. The feature size of the individual structure is typically between 5 µm and 100 micrometer.

A diffractive diffusor is arranged to diffract the laser light and may comprise two-or multi-level gratings with a feature size in a plane of the substrate between 0.1 µm and 10 µm and a height difference perpendicular to the plane of the substrate in the order of a quarter of a emission wavelength of the laser arrangement to several wavelength.

The Vertical Cavity Surface Emitting Laser may be a bottom emitter which is arranged to emit laser light through the semiconductor substrate. The optical structure comprises a surface structure of the semiconductor substrate. The surface structure may comprise geometric structures as discussed with respect to the refractive diffusor or gratings as discussed with respect to the diffractive diffusor. The first distributed Bragg reflector, the active layer and the second distributed Bragg reflector maybe arranged on a first side of the semiconductor substrate. The surface structure may be arranged on a second side of the semiconductor substrate opposite to the first side of the semiconductor substrate. Providing the surface structure or optical structure on the second side of the semiconductor substrate which is not used for processing the semiconductor layers of the VCSEL or VCSELs may enable a simple processing or manufacturing of the surface structure. Furthermore, the semiconductor substrate usually consists of gallium arsenide with a refractive index of n = 3.5. The semiconductor substrate does therefore usually have the highest refractive index which further improves efficiency of the surface structure or optical structure.

The surface structure may, for example, be etched in the second side of the semiconductor substrate. The etching process may be performed prior or after processing the semiconductor layers of the VCSEL or VCSELs or more general the laser arrangement.

The surface structure may alternatively be processed by grinding, lapping, etching, soft-cushion imprint lithography followed by etching, UV-replication of a master structure on the wafer followed by an etch-transfer of the replicated structure in the substrate, electron or ion beam writing or Grey-scale lithography and etching and the like.

Use of very small feature sizes of the optical structure or surface structure may be preferred for better randomization and also to reduce direct back reflections in the laser cavity which may alter the laser emission characteristics. Optionally an AR-coating can be applied on the optical structure. Alternatively the optical structure comprises at least two different geometrical features. A first feature acting as a diffusing structure (e.g. microlenses with dimensions of around 20µm) and a second feature with a scale below the laser wavelength acting as AR-coating (reference: artificial moth-eye structures).

The laser arrangement may comprise an array of Vertical Cavity Surface Emitting Lasers arranged on the same semiconductor substrate. A thickness of the semiconductor substrate may be arranged such that laser light emitted by neighboring Vertical Surface Emitting Lasers intersect with each other in a plane of the optical structure. The surface structure may in this case be arranged such that a homogeneous emission of an emission surface of the semiconductor substrate is enabled.

Essentially the whole chip area or size of the semiconductor substrate of the bottom emitting VCSEL array may be used in this case to emit laser light emitted by a multitude of VCSELs. The thickness of the semiconductor substrate in combination with the optical structures is arranged in this case such that the VCSEL array appears to be one light source in which no individual VCSEL is visible.

The thickness of the semiconductor substrate may, for example, be at least the nearest distance between neighboring Vertical Surface Emitting Lasers (pitch of the VCSELs) divided by two times the tangent of halve of the laser emission angle of the laser light in the semiconductor substrate. The laser emission angle in the semiconductor substrate is transformed by means of the optical structure to the laser emission angle of the laser arrangement. This may enable using an optical structure or diffusor with a very small diffusion angle. The diffusion angle is defined as the full angle enclosing the optical axis and the angle at which the intensity is 50% of the maximum intensity behind the optical structure (with respect to the illumination source) if the optical structure is illuminated with a collimated (essentially parallel) laser beam.

The surface structure may be characterized by a diffusion angle between 2° and 20°, preferably between 2° and 8° and most preferably between 4° and 8°. The diffusion angle would in this case essentially be equal to the laser divergence angle in the semiconductor substrate. A surface structure with such a small diffusion angle in combination with a semiconductor substrate of sufficient thickness may result in a laser arrangement which can be evaluated in accordance with the lamp standard according to IEC 62471 instead of the laser standard IEC 60825. This may result in a less restrictive safety regulations and better acceptance of products comprising such a laser arrangement.

There may be essentially two different cases. The VCSEL array can in the first case (very small diffusion angle of around 2° or 3°) be evaluated in accordance with the lamp standard. The VCSEL array appears in this case to be a strong, potentially dangerous LED light source. A diffusion angle of more than 3° may enable a completely eye save laser (class 1 laser).

The Vertical Cavity Surface Emitting Laser or Lasers of the laser arrangement may alternatively be a top emitter which is arranged to emit laser light through a second distributed Bragg reflector in a direction pointing away from the semiconductor substrate. The second distributed Bragg reflector is arranged on a first side of the active layer. The semiconductor substrate is arranged on a second side of the active layer opposite to the first side of the active layer. The optical structure comprises at least one semiconductor layer arranged on a side of the second distributed Bragg reflector opposite to the side attached to the active layer.

The optical structure is characterized by a feature size which is smaller than the individual laser beam on the light-emitting facet of the individual VCSEL (typically diameter of 10 µm) to lower brightness of each individual VCSEL. This feature size has the consequence that the optical structure cannot be part of the second distributed Bragg reflector. The reflectivity of the second distributed Bragg reflector has therefore to be adapted such that each VCSEL starts lasing without an additional contribution to the reflectivity by means of the semiconductor to air interface. Furthermore, there may be one or more intermediate layers arranged between the second distributed Bragg reflector and one, two, three or more semiconductor layers comprised by the optical structure.

The at least one semiconductor layer may be arranged to increase the laser emission angle to at least 40°. The laser emission angle after passing the optical structure may be between 20° and 180°.

The second distributed Bragg reflector may be arranged to provide a reflectivity of at least 95%, more preferably at least 98% and most preferably at least 99%. A reflectivity of at least 95% maybe sufficient to enable lasing of each VCSEL without an additional contribution to the reflectivity by means of any optional layer between the semiconductor layer or layers of the optical structure and the second distributed Bragg reflector, the semiconductor layer or layers of the optical structure and the semiconductor air interface.

The optical structure may be a diffractive diffusor. The at least one semiconductor layer may be characterized in this case by a thickness of at least half of an emission wavelength of the at least one Vertical Cavity Surface Emitting Laser. Using a semiconductor layer with a thickness of at least half of the emission wavelength enables use of only one semiconductor layer in order to provide a diffractive diffusor to increase the laser emission angle of the laser arrangement comprising the VCSEL or the VCSEL array.

The thickness of the at least one semiconductor layer may be two, three, four or more times and emission wavelength of the VCSEL in order to provide the required emission angle. The optical structure shall be preferably optimized for minimized back reflection in the laser cavity e.g. by designing the diffractive optical element such that the back reflection for the laser wavelength is suppressed by deconstructive interference at the different facets. Alternatively, the diffusor is designed to have only back reflection with large angle to the optical axis, such that they do not hit the active area or are not coupled back in the laser cavity. An AR-coating can be applied on or comprised by the optical structure according to an alternative embodiment as described above.

According to a second aspect a method of fabricating a laser arrangement comprising at least one Vertical Cavity Surface Emitting Laser is provided. The method comprises the steps of:
providing a substrate,
providing a first electrode,
providing a first distributed Bragg reflector,
providing an active layer,
providing a second distributed Bragg reflector such that the active layer is sandwiched between the first distributed Bragg reflector and the second distributed Bragg reflector,
providing a second electrode such that an electrical current can be provided across the active layer by means of the first electrode and the second electrode, and
integrating an optical structure in a semiconductor layer structure of the laser arrangement, wherein the optical structure is arranged to increase a laser emission angle of the laser light for increasing eye safety of the laser arrangement.

The steps need not necessarily be performed in the order given above. Metal layers which are used to process, for example, the first and the second electrode are processed after the epitaxial semiconductor layers. Integration of the optical structure may, for example, be performed before or after processing the laser cavity. Processing step of the first electrode may depend on whether a top emitter or a bottom emitter is manufactured.

The optical structure may be integrated by several methods, among them grinding, lapping, etching, soft-cushion imprint lithography followed by etching, UV-replication of a master structure on the wafer followed by a etch-transfer of the replicated structure in the substrate and the like.

The optical structure may be covered by a planarization layer. The planarization layer is characterized by a lower refractive index than a material of the optical structure. The optical structure maybe designed with respect to the refractive index of the planarization layer in order to provide the desired laser emission angle. The planarization layer may be used to smooth the surface irregularities caused by the optical structure. The planarization layer may comprise materials like silicone, epoxy, polyimide, SiN and the like. The difference between the refractive index of the semiconductor layer structure (substrate or one or more semiconductor layers) which is used to manufacture the optical structure and the refractive index of the planarization layer is sufficient to increase the laser emission angle to fulfill the safety requirements. The planarization layer protects the optical structure and inhibits manipulation, for example, by means of silicone oils.

According to a further aspect a light emitting device is provided. The light emitting device comprises at least one laser arrangement as described above and a driver for driving the laser arrangement.

It shall be understood that the laser arrangement of claim 1-12 and the method of claim 14 have similar and/or identical embodiments, in particular, as defined in the dependent claims.

It shall be understood that a preferred embodiment of the invention can also be any combination of the dependent claims with the respective independent claim.

Further advantageous embodiments are defined below.

### BRIEF DESCRIPTION OF THE DRAWINGS:

These and other aspects of the invention will be apparent from and elucidated with reference to the embodiments described hereinafter.

The invention will now be described, by way of example, based on embodiments with reference to the accompanying drawings.

In the drawings:
Fig. 1 shows a principal sketch of a first laser arrangement
Fig. 2 shows a principal sketch of a second laser arrangement
Fig. 3 shows a principal sketch to explain the terms diffusion angle and laser emission angle
Fig. 4 shows a principal sketch of a third laser arrangement
Fig. 5 shows a principal sketch of a process flow of a method of fabricating a laser arrangement

In the Figures, like numbers refer to like objects throughout. Objects in the Figures are not necessarily drawn to scale.

### DETAILED DESCRIPTION OF EMBODIMENTS:

Various embodiments of the invention will now be described by means of the Figures.

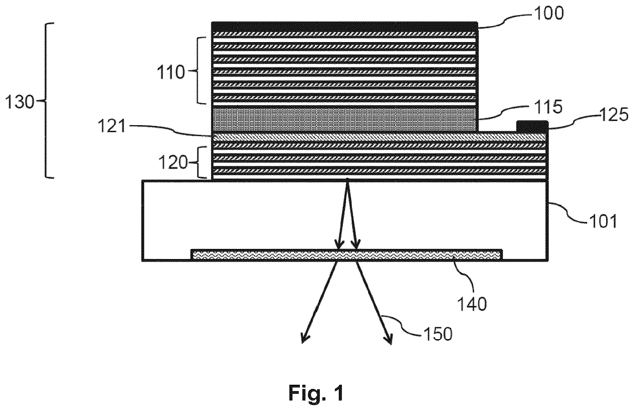

Fig. 1 shows a principal sketch of a first laser arrangement comprising one VCSEL. The VCSEL is a bottom emitting VCSEL emitting laser light in the direction of a semiconductor substrate 101. A second DBR 120 is provided on a first side of the semiconductor substrate 101 comprising, for example, 18 pairs of layers with alternating refractive indices. The reflectivity of the second DBR is around 95%, preferably around 99%. A bottom contact layer 121 is provided being arranged to distribute a current provided by means of a second electrode 125. The bottom contact layer 121 maybe a separate layer provided on top of the second DBR 120 or one of the layers of the second DBR 120. An active layer 115 is provided on top of the second DBR 120 followed by a first DBR 110 comprising, for example, 30 pairs of layers with alternating refractive indices. The reflectivity of the first DBR 110 is at least 99.9%. A first electrode 100 is provided on top of the first DBR 110. The first DBR 110, the active layer 115 and the second DBR and optional intermediate layers (not shown) built an optical resonator 130 of the VCSEL. An optical structure 140 is provided on a second side of the semiconductor substrate 101 opposite to the first side on which the second DBR 120 is arranged. The optical structure 140 is a surface structure which is etched in the surface of the second side of the semiconductor substrate 101. The surface structure is a refractive diffusor which is arranged to provide a laser emission angle of 40° of laser light 150 emitted by the first laser arrangement. The emission angle in the semiconductor substrate 101 may in this case be around 3° with respect to an optical axis of the first laser arrangement. The laser emission angle without the optical structure 140 would in this case be around 20° because of the refractive index of around 3.5 of the gallium arsenide semiconductor substrate 101. The optical structure 140 increases the laser emission angle of laser light 150 from 20° to 40°.

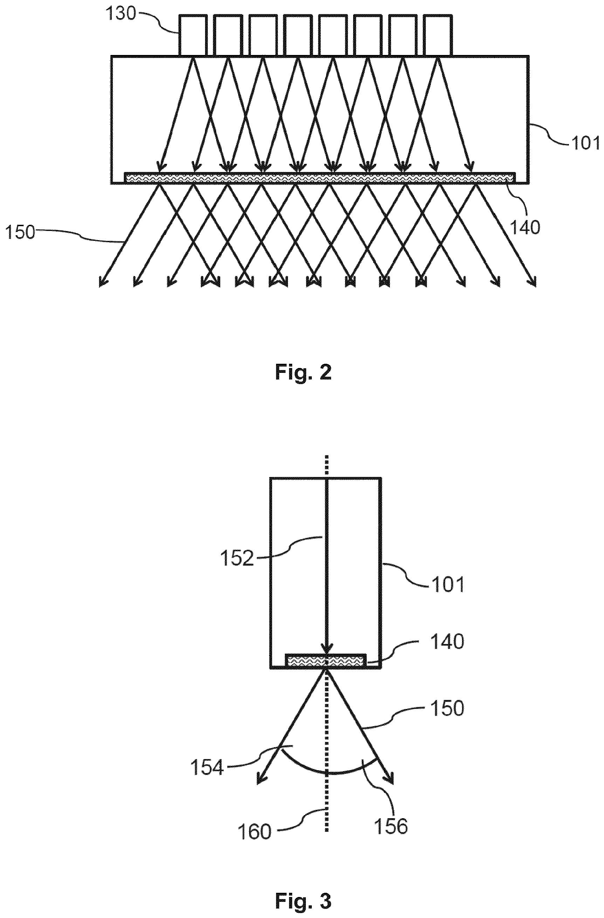

Fig. 2 shows a principal sketch of a cross-section of a second laser arrangement. The second laser arrangement comprises an array of VCSELs which are arranged in a two-dimensional array. Fig. 2 shows a cross-section across one line of laser cavities or optical resonators 130 of the VCSELs. A pitch between centers of the optical resonators 130 may be 40 µm. The laser emission angle within the semiconductor substrate 101 may be around 6° (circular symmetric around an optical axis of the respective VCSEL). A thickness of the semiconductor substrate 101 has to be at least around 380 µm in order to enable overlap of laser emission of single VCSELs in a plane of the optical structure 140. The overlap of the laser emission of the VCSELs in the plane of the optical structure 140 causes that essentially the whole bottom surface of the semiconductor substrate 101 appears to be a homogeneous light source. The laser emission angle of laser light 150 emitted by the second laser arrangement may be 30°. The emission cone of each VCSEL of the VCSEL array is only slightly widened by the optical structure 140. The thickness of the semiconductor substrate 101 (e.g. GaAs) in combination with the relatively small diffusion angle of the optical structure 140 have the effect that the surface of the semiconductor substrate 101 through which the laser light 150 is emitted appears to be a homogeneous emission surface. The second laser arrangement can therefore be can be evaluated in accordance with the lamp standard according to IEC 62471 instead of the laser standard IEC 60825 as discussed above.

Fig. 3 shows a principal sketch to explain the terms diffusion angle 154 and laser emission angle 156. Collimated laser light 152 is emitted via a semiconductor substrate 101 and diffused by an optical structure 140. The diffusion angle 154 is the full angle enclosing an optical axis 160 which is collinear with the collimated laser light 152 and the angles at which an intensity distribution of the laser light 150 in the far field after passing the optical structure 140 is 50% of a maximum intensity of the intensity distribution which may, for example, in case of a Gaussian intensity distribution be on the optical axis 160. The laser emission angle 156 is the full angle between the angles with respect to the optical axis 160 at which the intensity in the far field is 50% of the maximum intensity as discussed above. The laser emission angle 156 is in the special case of collimated laser light 152 identical with the diffusion angle 154.

The laser emission angle in the semiconductor substrate 101 laser light emitted by a VCSEL is not perfectly collimated as discussed above. The profile of laser light 150 emitted through the optical structure 140 is therefore a convolution of a profile of the, for example, laser light emitted by a VCSEL without the optical structure 140 and a diffusion profile of the optical structure 140. The diffusion profile of the optical structure 140 is blurred by the profile of the laser light. An optical structure 140 which provides, for example, a top hat diffusion profile may, for example, be transformed, to a trapezoidal shape (looking at the cross section). The laser emission angle 156 may therefore be wider in comparison to the case of the collimated laser light 152. Of course the diffusion profile should be optimized such that the laser emission profile is adapted to the requirements of the application. As the laser beam of the VCSEL itself is known, this can be included in the diffusor design.

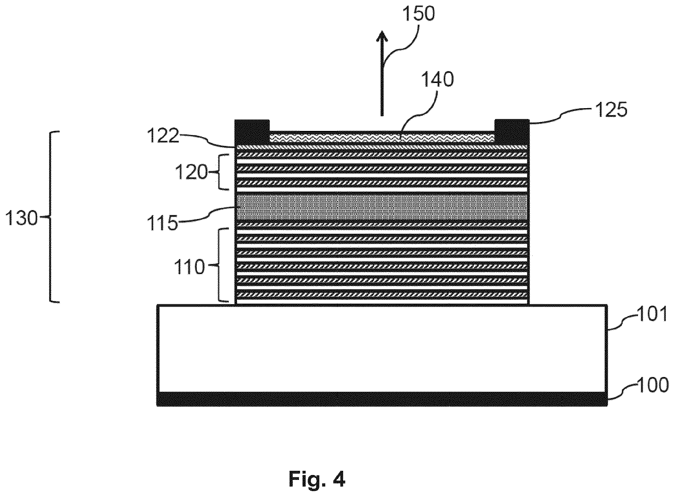

Fig. 4 shows a principal sketch of a cross section of a third laser arrangement. The third laser arrangement comprises a top emitting VCSEL emitting laser light 150 in a direction away from a substrate 101. On the bottom side of the semiconductor substrate 101a first electrode 100 is provided. On the top side of the semiconductor substrate 101 is a first DBR 110 provided comprising 30 pairs of layers with a first and a second refractive index. The pairs of layers of the first DBR 110 comprise AlGaAs/GaAs layers. The thickness of the layers is adapted to the emission wavelength of the VCSEL in order to provide the requested reflectivity of more than 99.9%. On top of the first DBR 110 is an active layer 115 provided. The active layer 115 comprises a quantum well structure for light generation. An n-current injection layer (not shown) may be arranged between the first DBR 110 and the active layer 115. A second DBR 120 is provided on top of the active layer 115. The second DBR comprises 15 pairs of layers with different refractive indices. The pairs of layers of the second DBR 120 comprise AlGaAs/GaAs layers. The thickness of the layers is adapted to the emission wavelength of the VCSEL in order to provide the requested reflectivity of around 99 %. A p-charge carrier injection layer and a current aperture (not shown) maybe arranged between the active layer 115 and the second DBR 120. A top contact layer 122 is provided between the second DBR 120 and an integrated optical structure 140. The optical structure 140 is a structured GaAs layer (diffractive grating) arranged to diffuse laser light 150 emitted by the laser arrangement in order to increase the laser emission angle as described above. A ring shaped second electrode 125 is electrically connected to the top contact layer 122 which distributes a current which can be supplied by means of the second electrode 125.

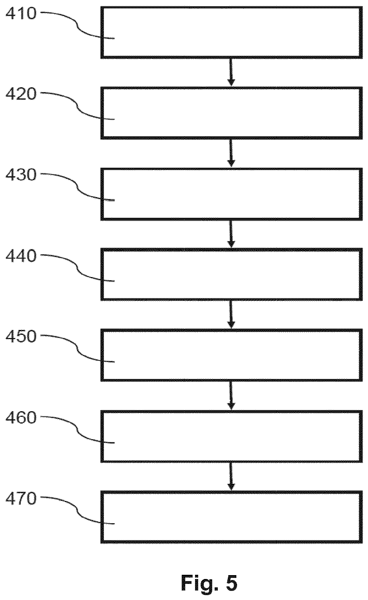

Fig. 5 shows a principal sketch of a process flow of a method of fabricating laser arrangement comprising a VCSEL. A GaAs semiconductor substrate 101 is provided in step 410. A first DBR 110 is provided on a top side of the substrate 101 in step 420 and an active layer 115 is provided in subsequent step 430 on top of the first DBR. On top of the active layer 115 is a second DBR provided in step 440. A structured GaAs layer is provided in step 450 on top of the second DBR 120. The structured GaAs layer is arranged as defusing optical structure 140 increasing the laser emission angle of the laser arrangement. A first electrode 100 is provided in step 460. The first electrode is attached to a bottom side of the semiconductor substrate 101.A second electrode 125 is provided in step 470 for electrically contacting the laser arrangement. The layers of the first DBR 110, the active layer 115, the second DBR, the integrated optical diffuser 140 and any other layer like current injection layers and the like may be deposited by epitaxial methods like MOCVD.

It is a basic idea of the present invention to integrate an optical structure 140 arranged to increase a laser emission angle of laser light 150 emitted by the laser arrangement in a semiconductor layer structure of the laser arrangement. The semiconductor layer structure comprises a semiconductor substrate 101 on which further epitaxial semiconductor layers are processed. The laser arrangement may finally be encapsulated by means of a package. Integration of the optical diffusing optical structure 140 in the semiconductor layer structure makes it nearly impossible to get access to the optical structure 140. Furthermore, the semiconductor layer structure of the laser arrangement has to be manipulated in order to avoid increasing of the laser emission angle. Manipulation of the sensitive semiconductor layer structure does usually have the effect that the laser light 150 emitting structure of laser arrangement is destroyed. Circumventing the optical structure 140 by means of a material (e.g. liquids) which may be used to smooth the optical structure 140 is essentially ineffective because it is nearly impossible to get access to the optical structure 140 and because of high refractive index of the semiconductor layers, especially the semiconductor substrate 101.

While the invention has been illustrated and described in detail in the drawings and the foregoing description, such illustration and description are to be considered illustrative or exemplary and not restrictive.

From reading the present disclosure, other modifications will be apparent to persons skilled in the art. Such modifications may involve other features which are already known in the art and which may be used instead of or in addition to features already described herein.

Variations to the disclosed embodiments can be understood and effected by those skilled in the art, from a study of the drawings, the disclosure and the appended claims. In the claims, the word "comprising" does not exclude other elements or steps, and the indefinite article "a" or "an" does not exclude a plurality of elements or steps. The mere fact that certain measures are recited in mutually different dependent claims does not indicate that a combination of these measures cannot be used to advantage.

Any reference signs in the claims should not be construed as limiting the scope thereof.

### LIST OF REFERENCE NUMERALS:

- 100: first electrode
- 101: substrate
- 110: first distributed Bragg reflector
- 115: active layer
- 120: second distributed Bragg reflector
- 121: bottom contact layer
- 122: top contact layer
- 125: second electrode
- 130: optical resonator
- 140: optical structure
- 150: laser light
- 152: collimated laser light
- 154: diffusing an angle
- 156: laser emission angle
- 410: step of providing substrate
- 420: step of providing first DBR
- 430: step of providing active layer
- 440: step of providing second DBR
- 450: step of integrating optical structure
- 460: step of providing second electrode
- 470: step of providing first electrode

## Claims

1. A laser arrangement comprising at least one Vertical Cavity Surface Emitting Laser being arranged to emit laser light (150), the at least one Vertical Cavity Surface Emitting Laser comprises a first electrode (100), a semiconductor substrate (101), a first distributed Bragg reflector (110), an active layer (115), a second distributed Bragg reflector (120) and a second electrode (125), wherein the active layer (115) is sandwiched between the first distributed Bragg reflector (110) and the second distributed Bragg reflector (120), wherein the first electrode (100) and the second electrode (125) are arranged to provide an electrical current across the active layer (115) to generate laser light (150), and wherein the laser arrangement comprises an optical structure (140) arranged to increase a laser emission angle (156) of the laser light (150) for increasing eye safety of the laser arrangement, wherein the optical structure (140) is an integrated part of a semiconductor layer structure of the laser arrangement.

2. The laser arrangement according to claim 1, wherein the optical structure (140) comprises a refractive diffusor or a diffractive diffusor.

3. The laser arrangement according to claim 1 or 2, wherein the Vertical Cavity Surface Emitting Laser is a bottom emitter which is arranged to emit laser light (150) through the semiconductor substrate (101), wherein the optical structure (140) comprises a surface structure of the semiconductor substrate (101).

4. The laser arrangement according to claim 3, wherein the first distributed Bragg reflector (110), the active layer (115) and the second distributed Bragg reflector (120) are arranged on a first side of the semiconductor substrate (101), and wherein the surface structure is arranged on a second side of the semiconductor substrate (101) opposite to the first side of the semiconductor substrate (101).

5. The laser arrangement according to claim 4, wherein the surface structure is etched in the second side of the semiconductor substrate (101).

6. The laser arrangement according to anyone of claims 3-5 comprising an array of Vertical Surface Emitting Lasers arranged on the same semiconductor substrate (101), wherein a thickness of the semiconductor substrate (101) is arranged such that laser light (150) emitted by neighboring Vertical Surface Emitting Lasers intersect with each other in a plane of the surface structure, and wherein the surface structure is arranged such that a homogeneous emission of an emission surface of the semiconductor substrate (101) is enabled.

7. The laser arrangement according to claim 6, wherein the thickness of the semiconductor substrate (101) is at least the nearest distance between neighboring Vertical Surface Emitting Lasers divided by two times the tangent of an emission angle of the laser light (150) in the semiconductor substrate (101).

8. The laser arrangement according to claim 7, wherein the surface structure is **characterized by** a diffusion angle between 2° and 20°, preferably between 2° and 8°, most preferably between 4° and 8°.

9. he laser arrangement according to claim 1 or 2, wherein the Vertical Cavity Surface Emitting Laser is a top emitter which is arranged to emit laser light (150) through the second distributed Bragg reflector (120), wherein the second distributed Bragg reflector (120) is arranged on a first side of the active layer (115), and wherein the semiconductor substrate (101) is arranged on a second side of the active layer (115) opposite to the first side of the active layer (115), and wherein the optical structure (140) comprises at least one semiconductor layer arranged on a side of the second distributed Bragg reflector (110) pointing away from the active layer (115).

10. The laser arrangement according to claim 9, wherein the at least one semiconductor layer is arranged to increase the laser emission angle to at least 40°.

11. The laser arrangement according to anyone of claims 9-10, wherein the optical structure (140) is a diffractive diffusor, and wherein the at least one semiconductor layer is **characterized by** a thickness of at least half of an emission wavelength of the at least one Vertical Cavity Surface Emitting Laser.

12. The laser arrangement according to anyone of the preceding claims, wherein the optical structure (140) is covered by a planarization layer, wherein the planarization layer is **characterized by** a lower refractive index than a material of the optical structure (140).

13. The laser arrangement according to anyone of the preceding claims, wherein the optical structure (140) comprises an antireflective coating, wherein the antireflective coating is arranged to reduce back reflection of laser light (150) to the optical resonator (130) of the Vertical Cavity Surface Emitting Laser.

14. The laser arrangement according to claim 13, wherein the optical structure (140) comprises at least two different geometrical features, wherein a first geometric feature is arranged to increase the laser emission angle, and wherein a second geometric feature with a feature size smaller than an emission wavelength of the laser light (150) acts as the antireflective coating.

15. A method of fabricating a laser arrangement comprising at least one Vertical Cavity Surface Emitting Laser, the method comprising the steps of:
providing a substrate (101),
providing a first electrode (100),
providing a first distributed Bragg reflector (110),
providing an active layer (115),
providing a second distributed Bragg reflector (120) such that the active layer (115) is sandwiched between the first distributed Bragg reflector (110) and the second distributed Bragg reflector (120),
providing a second electrode (125) such that an electrical current can be provided across the active layer (115) by means of the first electrode (100) and the second electrode (125), and
integrating an optical structure (140) in a semiconductor layer structure of the laser arrangement, wherein the optical structure (140) is arranged to increase a laser emission angle (156) of the laser light (150) for increasing eye safety of the laser arrangement.
